(19) **Europäisches Patentamt**

**European Patent Office**

**Office européen des brevets**

(11) Publication number : **0 463 827 A2**

(12) # EUROPEAN PATENT APPLICATION

(21) Application number : **91305657.8**

(51) Int. Cl.⁵ : **H04N 9/64,** H04N 9/04

(22) Date of filing : **21.06.91**

(30) Priority : **22.06.90 JP 164665/90**
**06.07.90 JP 177249/90**

(43) Date of publication of application :
**02.01.92 Bulletin 92/01**

(84) Designated Contracting States :
**DE FR GB**

(71) Applicant : **SONY CORPORATION**
**7-35 Kitashinagawa 6-Chome Shinagawa-ku**
**Tokyo 141 (JP)**

(72) Inventor : **Asaida, Takashi, c/o Patents**
**Division**
**Sony Corporation, 6-7-35 Kitashinagawa**
**Shinagawa-ku, Tokyo 141 (JP)**

(74) Representative : **Thomas, Christopher Hugo et**
**al**
**D Young & Co 10 Staple Inn**
**London WC1V 7RD (GB)**

(54) **Video cameras.**

(57)    In a video camera output signals from an imaging device (1, 2) are processed to produce digital video signals. Three colour signals derived by first, second and third solid-state imaging devices (2G, 2R, 2B) are converted (6GE, 6RO, 6RE, 6RO, 6BE, 6BO) into digital signals, and the three digital colour signals and a digital composite video signal formed from these three digital colour signals are outputted at respective output terminals (17B, 17R, 17B, 16CS).

EP 0 463 827 A2

**FIG.1**

This invention relates to video cameras.

A so-called separate type video camera, in which a camera head unit (CHU) having an imaging device, and a camera control unit (CCU) having an analogue signal processing circuit such as an encoder for producing a composite video signal of a standard television system such as the NTSC system from an imaging output supplied from the CHU, and a control signal generator for generating control signals supplied to the CHU, are interconnected by a multi-core camera cable, is disclosed in, for example, Japanese kokai patent specification 2/280580.

There is also known a video camera not provided with a CCU, that is, provided only with a CHU having a signal processing circuit such as an encoder, or a synchronization signal generator, incorporated therein, and arranged to supply a composite video signal of a standard television system.

These video cameras supply analogue composite video signals and analogue luminance and colour difference signals.

Recently, digital electronic equipment, such as digital video tape recorders (VTRs) for recording and/or reproducing video signals in the form of digital signals, have come into use.

However, with the above video cameras, the signals of the imaging device are processed and supplied in the form of analogue signals, so that, when interconnecting the video camera and, for example, a digital VTR, it is necessary to provide an analogue to digital converter at an interface between the video camera and the VTR. There is also a problem that signal deterioration may be produced in the transmission line from the video camera to the analogue to digital converter, over which the video signals are transmitted in the form of analogue signals.

According to the present invention there is provided a video camera for processing output signals from an imaging device to form video signals, the camera comprising:
analogue to digital converting means for converting three colour signals outputted from first, second and third solid-state imaging devices into digital signals;
signal processing means for processing output signals from said analogue to digital converting means for forming a digital composite video signal;
a first output terminal for outputting three colour signals digitized by said analogue to digital converting means;
a second output terminal for outputting said digital composite video signal formed by said signal processing means.

According to the present invention there is also provided a camera for processing output signals of an imaging device for forming video signals, the camera comprising:
analogue to digital converting means for converting three colour signals outputted from first, second and third solid-state imaging devices into digital signals;
signal processing means supplied with output signals of said analogue to digital converting means and arranged to form a digital composite video signal;
switching means for selectively outputting the three digitized colour signals supplied from said analogue to digital converting means or the digital composite video signal supplied from said signal processing means;
parallel to serial converting means for converting output signals of said switching means into serial data; and
an output terminal for outputting output signals of said parallel to serial converting means.

According to the present invention there is also provided a video camera for processing output signals of an imaging device for forming video signals, the camera comprising:
analogue to digital converting means for converting output signals of said imaging device into digital signals;
signal processing means for processing output signals of said analogue to digital converting means for forming digital composite video signals of a predetermined format;
parallel to serial converting means for converting output signals of said signal processing means into serial data; and
an output terminal for outputting output signals of said parallel to serial converting means.

According to the present invention there is also provided a video camera for processing output signals of an imaging device for forming video signals, the camera comprising:
analogue to digital converting means for converting output signals of said imaging device into digital signals;
signal processing means for processing output signals of said analogue to digital converting means to form digital video signals of a predetermined format;
parallel to serial converting means for converting output signals of said analogue to digital converting means into serial data;
a first output terminal for outputting the digital video signals formed by said signal processing means; and
a second output terminal for outputting said serial data from said parallel to serial converting means.

According to the present invention there is also provided a video camera for processing output signals of an imaging device to form video signals, the camera comprising:
a camera head unit comprising analogue to digital converting means for converting output signals of said imaging device into digital signals, and parallel to serial converting means for converting output signals of said analogue to digital converting means into serial data;
transmission means for transmitting serial data outputted from said parallel to serial converting means of said camera head unit; and

a camera control unit comprising serial to parallel converting means for converting said serial data supplied from said parallel to serial converting means by said transmission means into parallel data, signal processing means for processing output signals of said serial to parallel converting means to form digital video signals of a predetermined format, and an output terminal for outputting the video signals formed by said signal processing means.

According to the present invention there is also provided a video camera for processing output signals of an imaging device to form video signals, the camera comprising:

a camera head unit comprising a solid-state imaging device from the totality of pixels of which imaging signals are read independently field by field on the basis of driving pulses supplied from driving means for said imaging device, analogue to digital converting means for converting said imaging signals outputted from said solid-state imaging device into digital signals, and parallel to serial converting means for converting output signals of said analogue to digital converting means into serial data;

transmission means for transmitting said serial data outputted from said parallel to serial converting means of said camera head unit; and

a camera control unit comprising serial to parallel converting means for converting said serial data transmitted by said transmission means from said parallel to serial conversion means into parallel data, signal processing means for processing output signals of said serial to parallel converting means to form digital video signals of a predetermined format, and an output terminal for outputting said digital video signals formed by said signal processing means.

The present invention also provides a video camera for processing output signals of an imaging device for forming video signals, the camera comprising a camera head unit comprising analogue to digital converting means for converting output signals of said imaging device into digital signals, and parallel to serial converting means for converting output signals of said analogue to digital converting means into serial data, transmission means for transmitting serial data outputted from said parallel to serial converting means of said camera head unit, and a camera control unit comprising serial to parallel converting means for converting said serial data supplied from said parallel to serial converting means by said transmission means into parallel data, image converting means for performing image conversion processing on output signals from said serial to parallel converting means, signal processing means for processing output signals of said image converting means to form digital video signals of a predetermined format, and an output terminal for outputting the video signals formed by said signal processing means.

With an embodiment of video camera according to the present invention, since the three colour signals outputted from first, second and third solid-state imaging devices are converted into digital signals, digital composite video signals can be produced on the basis of the digitized colour signals, and the digitized colour signals and a digital composite video signal can be outputted. Thus the output video signals can be supplied to an external electronic system having a digital signal processing circuit, without the interposition of an interface including an analogue to digital converter.

Moreover, the three colour signals from the first, second and third solid-state imaging devices can be converted into digital signals, a digital composite video signal can be produced on the basis of the digital colour signals, the digital colour signals or the digital composite video signal can be selected by switching means, and the selected signals can be converted into serial data so as to be outputted. Thus the video signals suited to the video signal input mode of an external electronic system having a digital signal processing circuit can be selectively supplied.

The invention will now be described by way of example with reference to the accompanying drawings, throughout which like parts are referred to by like references, and in which:

Figure 1 is a block diagram of a camera head unit for an embodiment of video camera according to the present invention;

Figure 2 is a schematic view of a solid-state imaging device employed in the camera of Figure 1;

Figure 3 is a block diagram of a camera control unit of the camera of Figure 1;

Figure 4 is a block diagram of another camera head unit of the camera of Figure 1;

Figure 5 is a schematic view showing the relative disposition between the solid-state imaging devices of the camera head unit of Figure 4;

Figures 6A to 6I are charts illustrating the operation of the camera head unit of Figure 4;

Figure 7 is a block diagram of a signal processing means of the camera head unit of Figure 4;

Figure 8 is a block diagram of a colour encoder of the camera head unit of Figure 4; and

Figures 9 to 11 are block diagrams of different adapter units mounted on the camera head unit of Figure 4.

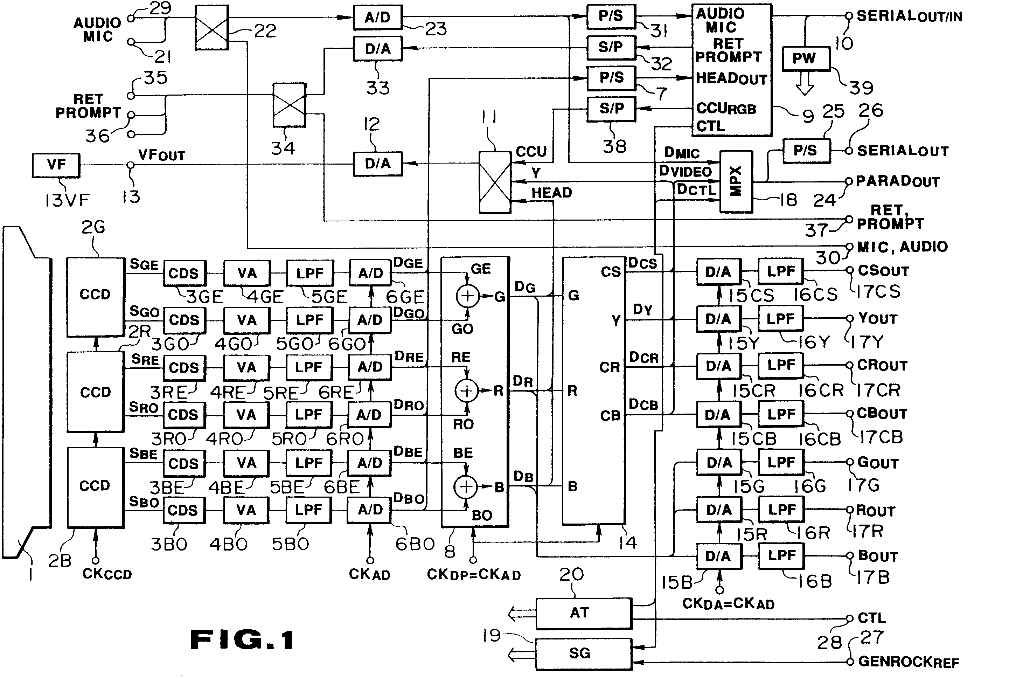

In the camera head unit (CHU), shown in Figure 1, the present invention is applied to a three charge coupled device (CCD) solid-state colour imaging device in which the imaging light from an object is separated by an imaging pick-up device 1 into three primary colour components, and three primary colour object images are produced on three solid-state imaging sensors 2R, 2G and 2B.

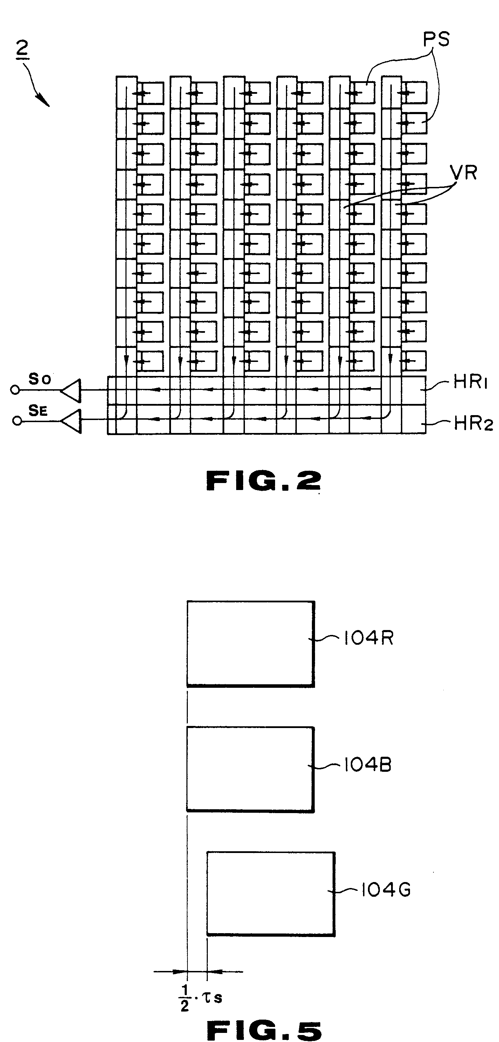

A respective two-line-concurrent reading type high resolution CCD imaging sensor 2, formed of a CCD as shown in Figure 2, forms each of the three sensors 2R, 2G and 2B forming an image pick-up section of the CHU. The sensor 2 is provided with a plurality of vertical transfer registers VR, arranged in a vertical direction along associated photosensor units PS arrayed in a matrix in a one-to-one relation with respect to pixels, and two horizontal transfer registers $HR_1$ and $HR_2$, arranged in juxtaposition at the ends of the vertical transfer registers VR. With the sensor 2, the imaging outputs, obtained at the photosensor units PS, are independently transferred by means of the vertical transfer registers VR, at a rate of two horizontal lines at each horizontal scanning period, to the horizontal transfer registers $HR_1$ and $HR_2$, so that odd-line imaging outputs $S_o$ are sequentially read by the horizontal transfer register $HR_1$ and evenline imaging outputs $S_E$ are sequentially read by the horizontal transfer register $HR_2$. That is, the imaging outputs for the pixels are read out for each field by means of the two horizontal transfer registers $HR_1$ and $HR_2$.

The three sensors 2R, 2G and 2B are driven by a CCD driving circuit, not shown, providing driving clocks $CK_{CCD}$ having a frequency of, for example, 21.5 MHz.

The sensor 2R produces a red colour image of the object image. An odd-line number red colour image output signal $S_{RO}$ and an even-line number red colour image output signal $S_{RE}$, read out simultaneously from the sensor 2R, are supplied to level adjustment circuits 4RO and 4RE by way of correlation dual sampling circuits 3RO and 3RE, respectively. The sensor 2G produces a green colour image of the object image. An odd-line number green colour image output signal $S_{GO}$ and an even-line number green colour image output signal $S_{GE}$, read out simultaneously from the image sensor 2G, are supplied to level adjustment circuits 4GO and 4GE by way of correlation dual sampling circuits 3GO and 3GE, respectively. Finally, the sensor 2B produces a blue colour image of the object image. An odd-line number blue colour imaging output signal $S_{BO}$ and an even-line number blue colour imaging output signal $S_{BE}$, read out simultaneously from the sensor 2B, are supplied to level adjustment circuits 4BO and 4BE, by way of correlation dual sampling circuits 3BO and 3BE, respectively.

The correlation dual sampling circuits 3RO, 3RE, 3GO, 3GE, 3GO and 3BE process the colour imaging output signals $S_{RO}$ $S_{RE}$, $S_{GO}$, $S_{GE}$, $S_{BO}$ AND $S_{BE}$, read out two lines at a time from the sensors 2R, 2G and 2B, by clamping reset noise levels and sample-holding the output levels on the basis of the clamped noise level for reducing the reset noise. The level adjustment circuits 4RO, 4RE, 4GO, 4GE, 4BO and 4BE perform level adjustment, such as white balance adjustment, on the colour imaging output signals $S_{RO}$

$S_{RE}$, $S_{GO}$, $S_{GE}$, $S_{BO}$ and $S_{BE}$, which have been processed for reducing the reset noise. The colour imaging output signals $S_{RO}$, $S_{RE}$, $S_{GO}$, $S_{GE}$, $S_{BO}$ and $S_{BE}$, after being processed for level adjustment are transmitted by way of low-pass filters 5RO, 5RE, 5GO, 5GE, 5BO and 5BE, respectively, to A/D converters 6RO, 6RE, 6GO, 6GE, 6BO and 6BE, functioning as analogue/digital converting means, respectively.

Driving clocks $CK_{AD}$ having a frequency of four times the frequency of the colour sub-carrier frequency $f_{SC}$, or $4f_{SC}$, are supplied to the A/D converters 6RO, 6RE, 6GO, 6GE, 6BO and 6BE, by a timing generator, not shown. The A/D converters 6RO, 6RE, 6RO, 6GE, 6BO and 6BE digitize the colour imaging output signals $S_{RO}$, $S_{RE}$, $S_{GO}$, $S_{GE}$, $S_{BO}$ and $S_{BE}$ with the $4f_{SC}$ driving clocks $CK_{AD}$ to produce two-line-concurrent digital three colour signals $D_{RO}$, $D_{RE}$, $D_{GO}$, $D_{GE}$, $D_{BO}$ and $D_{BE}$, respectively. The digital colour signals $D_{RO}$, $D_{RE}$, $D_{GO}$, $D_{GE}$, $D_{BO}$ and $D_{BE}$ so obtained are supplied to a parallel/serial (P/S) converter 7 and to a signal processing section 8.

The P/S converter 7 changes the digital colour signals $D_{RO}$, $D_{RE}$, $D_{GO}$, $D_{GE}$, $D_{BO}$ and $D_{BE}$, supplied from the A/D converters 6RO, 6RE, 6GO, 6GE, 6BO and 6BE, from parallel data into serial data. The serial data are then supplied as camera output data HEAD OUT to an optical encoder/decoder 9 which encodes the serial data, and outputs the encoded data at a serial input/output port 10 to an optical fibre cable, not shown.

The signal processing section 8 adds the digital colour signals $D_{RO}$, $D_{RE}$, $D_{GO}$, $D_{GE}$, $D_{BO}$ and $D_{BE}$, supplied from the A/D converters 6RO, 6RE, 6GO, 6GE, 6BO and 6BE, in pairs, in such a manner that switching between upper and lower lines on both sides of a centre line is made on a field-by-field basis to form interlaced digital colour signals $D_R$, $D_G$ and $D_B$. The signal processing section 8 also processes the digital colour signals $D_R$, $D_G$ and $D_B$, for example, to provide gamma correction and image enhancement.

The interlaced digital colour signals $D_R$, $D_G$ and $D_B$ are supplied by a selector 11 to a digital to analogue (D/A) converter 12, by which they are converted into corresponding analogue signals which are outputted as an output terminal 13 as an imaging signal $VF_{OUT}$ for a viewfinder 13VF connected to the output terminal 13.

The interlaced digital colour signals $D_R$, $D_G$ and $D_B$ are also supplied to a colour encoder 14 and to D/A converters 15R, 15G and 15B.

The D/A converters 15R, 15G and 15B process the interlaced digital colour signals $D_R$, $D_G$ and $D_B$ into corresponding analogue colour signals $R_{OUT}$, $G_{OUT}$ and $B_{OUT}$ which are outputted at output terminals 17R, 17G and 17B, via low-pass filters 16R, 16G and 16B, respectively.

The colour encoder 14, designed for forming digital video signals of a predetermined format compatible with standard television systems, such as the NTSC system, produces digital component video signals of, for example, the NTSC system, composed of a digital luminance signal $D_Y$ and digital colour difference signals $D_{CR}$ and $D_{CB}$, from the digital colour signals $D_R$, $D_G$ and $D_B$, interlaced and processed with gamma correction and image enhancement by the signal processing section 8, while also producing a digital composite video signal $D_{CS}$ of the NTSC system.

The NTSC system digital component signals $D_Y$, $D_{CR}$ and $D_{CB}$, derived by the colour encoder 14, are supplied to the D/A converters 15Y, 15CR and 15CB, respectively, which change the digital component signals $D_Y$, $D_{CR}$ and $D_{CB}$ into analogue component signals $Y_{OUT}$, $CR_{OUT}$ and $CB_{OUT}$ of the NTSC system. These analogue component signals $Y_{OUT}$, $CR_{OUT}$ and $CB_{OUT}$ are outputted at output terminals 17Y, 17CR and 17CB, by way of low-pass filters 16Y, 16CR and 16CB respectively.

The digital composite signal $D_{CS}$ of the NTSC system is supplied to the D/A converter 15CS which changes it into an analogue composite image signal $CS_{OUT}$ of the NTSC system which is outputted at an output terminal 17CS via a low-pass filter 16CS.

The digital component signals $D_Y$, $D_{CR}$ and $D_{CB}$ and the digital composite signal $D_{CS}$ of the NTSC system, obtained by the colour encoder 14, are also supplied to a multiplexer 18. The luminance signal $D_Y$ is also supplied to the D/A converter 12 by means of the selector 11, and changed into corresponding analogue signals by the D/A converter 12 so as to be supplied at the output terminal 13 to the viewfinder 13VF.

The multiplexer 18 is supplied with control data $D_{CTL}$ from a synchronizing circuit block 19 and a control circuit block 20, while being supplied with voice data $D_{MIC}$, which are the microphone signal inputted from a microphone input terminal 21 by a selector 22 and digitized by an A/D converter 23. The multiplexer 18 adds the signals $D_{CTL}$ and $D_{MIC}$ to digital video signals VIDEO composed of the digital component signals $D_Y$, $D_{CR}$ and $D_{CB}$ or the digital composite signal $D_{CS}$ from the colour encoder 14. Output data $D_{MPX}$ from the multiplexer 18, these are the digital video signals $D_{VIDEO}$ with the control data $D_{CTL}$ and the voice data $D_{MIC}$ added, are outputted in parallel at a parallel output port 24, while being converted by a P/S converter 25 from parallel data into serial data which are serially outputted at a serial output port 26.

Meanwhile, the synchronizing circuit block 19 is supplied with a reference synchronizing signal $GEN_{REF}$ for generator locking, from an input terminal 27, while the control circuit block 20 is supplied with a control signal CTL from an input terminal 28.

The selector 22 selects the microphone input signal MIC inputted from the input terminal 21, or the audio signal AUDIO, inputted at an input terminal 29, and passes the selected signal to the A/D converter 23 and to an output terminal 30. The A/D converter 23 digitizes the microphone input signal MIC or the audio signal AUDIO, selectively inputted by means of the selector 22. Audio output data $D_{MIC/AUDIO}$ from the A/D converter 23 are supplied to the multiplexer 18, while being converted by a P/S converter 31 from parallel data into serial data, so as to be serially outputted at the serial input/output port 10 by way of the encoder/decoder 9.

The encoder/decoder 9 encodes the serial data supplied from the P/S converters 7 and 31 and serially transmits the encoded serial data from the serial input/output port 10 to a camera control unit (CCU) as later described, while also decoding various serial data transmitted from the CCU to the serial input/output port 10, such as return video signals $D_{RET}$, prompter signals $D_{PROMPT}$, output signals $CCU_{OUT}$ from the CCU or control data CTL.

The video data $D_{RET}$ and $D_{PROMPT}$, decoded by the encoder/decoder 9, are converted by a S/P converter 32 from serial data into parallel data, which are converted by a D/A converter 33 into analogue signals, which in turn are outputted by means of a selector 34 at output terminals 35 and 36. The selector 34 selects the analogue video signals RET and PROMPT, supplied to an input terminal 37 or the video signals converted into analogue signals by the A/D converter 33 and outputs the selected signals at the output terminals 35 and 36. Various monitoring devices, not shown, are connected to the output terminals 35 and 36. The CCU-outputted video data $CCU_{OUT}$, decoded by the encoder/decoder 9, are converted by a S/P converter 38 from serial data into parallel data before being supplied by means of the selector 11 to the D/A converter 12. The parallel data are converted by the D/A converter 12 into analogue data, which are then supplied at the output terminal 13 to the viewfinder 13VF.

The CHU is driven by driving power supplied from the CCU to a power source circuit 39 over a power cable enclosed in an optical fibre cable connected to the serial input/output port 10.

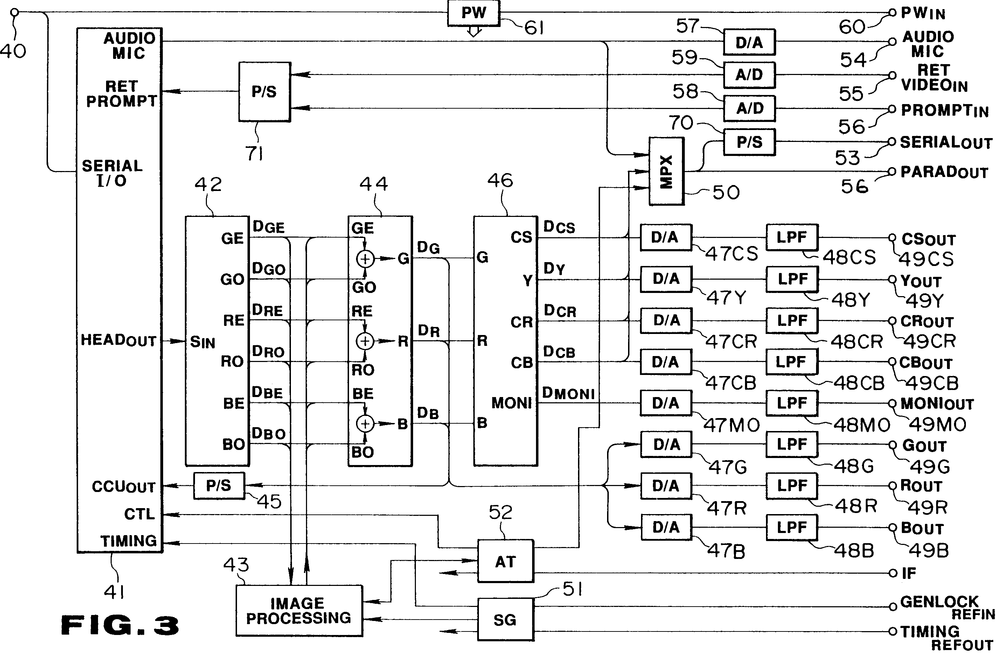

An embodiment of video camera according to the present invention is formed by the CHU of Figure 1 and the CCU arranged and constructed as shown in Figure 3.

The CCU is provided with a serial input/output port 40, as shown in Figure 3, which is connected to the serial input/output port 10 of the CHU by an optical fibre cable, not shown.

To the serial input/output port 40 is connected an encoder/decoder 41 corresponding to the encoder/decoder 9 of the CHU. The encoder/decoder 41 decodes serial data transmitted from the CHU to the serial input/output port 40 over the optical fibre cable to decode the serial video output data $HEAD_{OUT}$, that is the two-line-concurrent digital three-

colour signals $D_{RO}$, $D_{RE}$, $D_{GO}$, $D_{GE}$, $D_{BO}$ and $D_{BE}$, to supply the decoded data to a S/P converter 42. The S/P converter 42 converts the serial video output data $HEAD_{OUT}$ into parallel two-line-concurrent digital three-colour signals $D_{RO}$, $D_{RE}$, $D_{GO}$, $D_{GE}$, $D_{BO}$ and $D_{BE}$. These digital colour signals $D_{RO}$, $D_{RE}$, $D_{GO}$, $D_{GE}$, $D_{BO}$ and $D_{BE}$ are transmitted to an image processing section 43 and a signal processing section 44.

The image processing section 43 processes the digital colour signals $D_{RO}$, $D_{RE}$, $D_{GO}$, $D_{GE}$, $D_{BO}$ and $D_{BE}$ digitally for correcting optical effects of the pick-up device 1 of the CHU, and for converting the television signals into extended (high) definition television signals. The digital colour signals $D_{RO}$, $D_{RE}$, $D_{GO}$, $D_{GE}$, $D_{BO}$ and $D_{BE}$, thus processed by the image processing section 43, are supplied to the signal processing section 44.

The signal processing section 44 adds the digital colour signals $D_{RO}$, $D_{RE}$, $D_{GO}$, $D_{GE}$, $D_{BO}$ and $D_{BE}$ supplied from the P/S converter 42, and the digital colour signals $D_{RO}$, $D_{RE}$, $D_{GO}$, $D_{GE}$, $D_{BO}$ and $D_{BE}$ processed by the image processing section 43, for each of the colour signals, in such a manner that switching between upper and lower lines on both sides of a centre line is effected field-by-field to produce interlaced digital colour signals $D_R$, $D_G$ and $D_B$. The signal processing section 44 also processes the digital colour signals $D_R$, $D_G$ and $D_B$, for example, for gamma correction and image enhancement.

The interlaced digital colour signals $D_R$, $D_G$ and $D_B$, obtained by the signal processing section 44, are supplied to a P/S converter 45, whereby they are converted from parallel data into serial data. These serial data are supplied as the CCU-outputted video data $CCU_{OUT}$ to the encoder/decoder 41 which encodes this serial data to output the encoded data at the serial input/output port 40 to an optical fibre cable, not shown.

Thus, in the CCU, the digital colour signals $D_{RO}$, $D_{RE}$, $D_{GO}$, $D_{GE}$, $D_{BO}$ and $D_{BE}$, obtained by the P/S converter 42, are processed by interlacing by the signal processing section 44 either directly or after image processing by the image processing section 43, and the resulting digital colour signals $D_R$, $D_G$ and $D_B$ are serially outputted to the CHU. In the CHU, the image corresponding to the CCU-outputted video data $CCU_{OUT}$, serially transmitted from the CCU to the serial input/output port 10, is displayed in the viewfinder 13FV.

The digital colour signals $D_R$, $D_G$ and $D_B$, obtained by the signal processing section 44, are supplied to a colour encoder 46, and are also supplied to D/A converters 47R, 47G and 47B for processing into corresponding analogue signals to form analogue output signals $R_{OUT}$, $G_{OUT}$ and $B_{OUT}$ which are outputted at output terminals 49R, 49G and 49B by way of low-pass filters 48R, 48G and 48B, respectively.

The colour encoder 46 produces digital video signals of a predetermined format compatible with a standard television system, such as the NTSC system. Thus the colour encoder 46 produces digital component video signals of, for example, the NTSC system, composed of the digital luminance signal $D_Y$ and digital colour difference signals $D_{CR}$ and $D_{CB}$, from the digital colour signals $D_R$, $D_G$ and $D_B$ processed by the signal processing section 44, while also producing the digital composite video signal $D_{CS}$ and the monitoring digital video signals $D_{MONI}$ of the NTSC system.

The digital component signals $D_Y$, $D_{CR}$ and $D_{CB}$ obtained by the colour encoder 46, are supplied to the D/A converters 47Y, 47CR and 47CB, respectively, which process them into corresponding analogue component signals $Y_{OUT}$, $CR_{OUT}$ and $CB_{OUT}$. These analogue component signals $Y_{OUT}$, $CR_{OUT}$ and $CB_{OUT}$ are output ted via the low-pass filters 48Y, 48CR and 48CB at the output terminals 49Y, 49CR and 49CB, respectively.

The digital composite video signal $D_{CS}$ produced by the colour encoder 46 is supplied to the D/A converter 47CS which processes it into a corresponding analogue composite signal $CS_{OUT}$ of the NTSC system, which is then outputted via a low-pass filter 48CS at an output terminal 49CS.

The monitoring digital video signal $D_{MONI}$ produced by the colour encoder 46 is supplied to a D/A converter 47MO which processes it into a corresponding analogue monitoring video signal $MONI_{OUT}$ which is outputted via a low-pass filter 48MO at an output terminal 49MO.

The digital component video signals $D_Y$, $D_{CR}$ and $D_{CB}$ and the digital composite video signal $D_{CS}$ produced by the encoder 46, are supplied to a multiplexer 50.

The multiplexer 50 is supplied with control data $D_{CTL}$ from a synchronizing circuit blow 51 or a control circuit block 52 and with audio data $D_{MIC/AUDIO}$ decoded by the encoder/decoder 41 from serial data transmitted from the CHU to the serial input/output port 40 over theoptical fibre cable, and adds these signals to digital video signals VIDEO produced as digital component signals $D_Y$, $D_{CR}$ and $D_{CB}$ or a digital composite signal $D_{CS}$ from the colour encoder 46. Output data $D_{MPX}$ from the multiplexer 50, that is the digital video signals $D_{VIDEO}$ with the control data $D_{CTL}$ and voice data $D_{MIC}$ added, are outputted in parallel at a parallel output port 56, while being converted by a P/S converter 70 from parallel data into serial data so as to be serially outputted at a serial output port 53.

Meanwhile, the audio data $D_{MIC/AUDIO}$, decoded by the encoder/decoder 41, are processed by an A/D converter 57 into corresponding analogue signals which are outputted at an audio output terminal 54.

The CCU is also provided with A/D converters 59 and 58 for digitizing various video signals supplied thereto at a video input terminal 55 from an external device, not shown, such as a return video signal RET VIDEO or a prompter signal PROMPT, and with a P/S converter 71 for converting the digitized video data from the A/D converters 59 and 58 from parallel data into serial data so as to be serially outputted at the serial input/output port 40.

Thus, with this video camera system, the video signals obtained by the CHU are digitized and serially transmitted from the CHU to the CCU, whilst video signals supplied from an external system to the CCU are digitized and serially transmitted from the CCU to the CHU.

The CCU is driven by power supplied from a power source input terminal 60 to a power source circuit 61, from which power is supplied to the power source circuit 39 of the CHU over a power cable enclosed within an optical fibre cable connected to the serial input/output port 40.

With the above described video camera, the output signals from the pick-up device 1 are converted into digital signals which then are processed in a predetermined manner to produce digital composite video signals of a predetermined format, which in turn are converted into serial data so as to be outputted, so that a video camera is provided which may be connected electrically over a reduced number of transmission lines to an external electronic system having a digital signal processing circuit.

Also, with this video camera, the output signals of the pickup device 1 are converted into digital signals, which are then converted into serial data, which serial data are transmitted by transmission means to the CCU. The transmitted serial data are converted into parallel data and processed in a predetermined manner to produce digital video signals of a predetermined format which are outputted. Thus a video camera is provided which enables digital video signals to be transmitted between the CHU and the CCU over a reduced number of transmission lines.

Furthermore, with this video camera, the output signals of the pick-up device 1 are converted into digital signals, which are then converted into serial data, which are transmitted by transmission means to a CCU so as to be converted into parallel data. These parallel data are processed by image conversion and predetermined signals processing to produce digital video signals of a predetermined format, which are outputted. In this manner, a video camera is provided which enables image signals to be processed by image conversion within the CCU.

A modified embodiment of video camera according to the present invention will now be described.

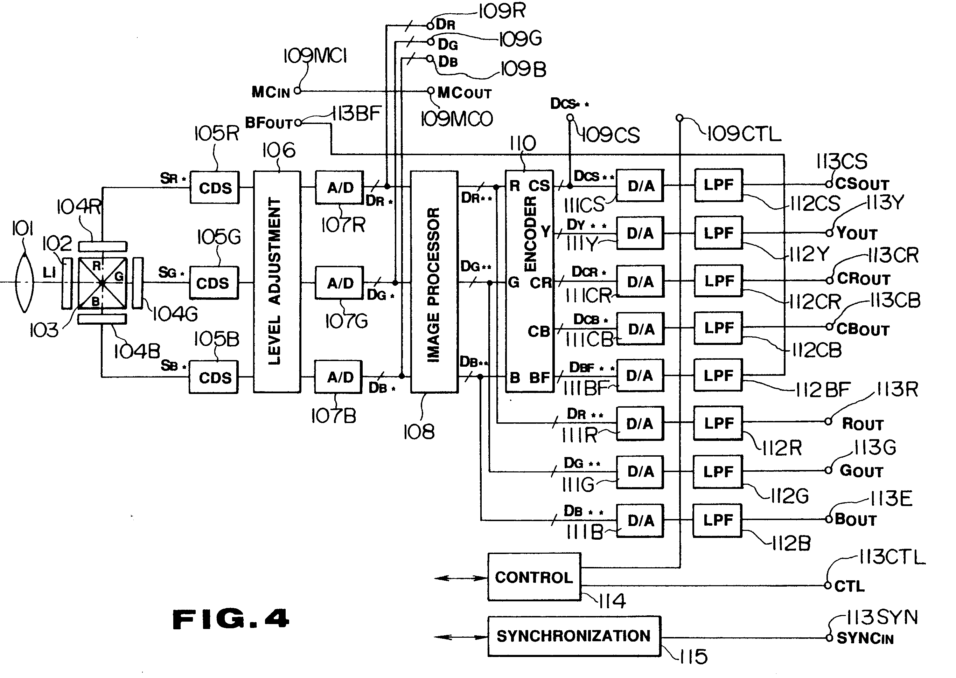

Figure 4 shows a modified camera head unit (CHU) of a video camera of the NTSC system in which the present invention is applied to a three CCD solid-state imaging device in which an imaging light $L_i$ incident thereon from an imaging lens 101 by means of an optical low-pass filter 102 is separated by a colour separation prism 103 into three-colour light components, and three colour images of an object are produced by three CCD image sensors 104R, 104G and 104B.

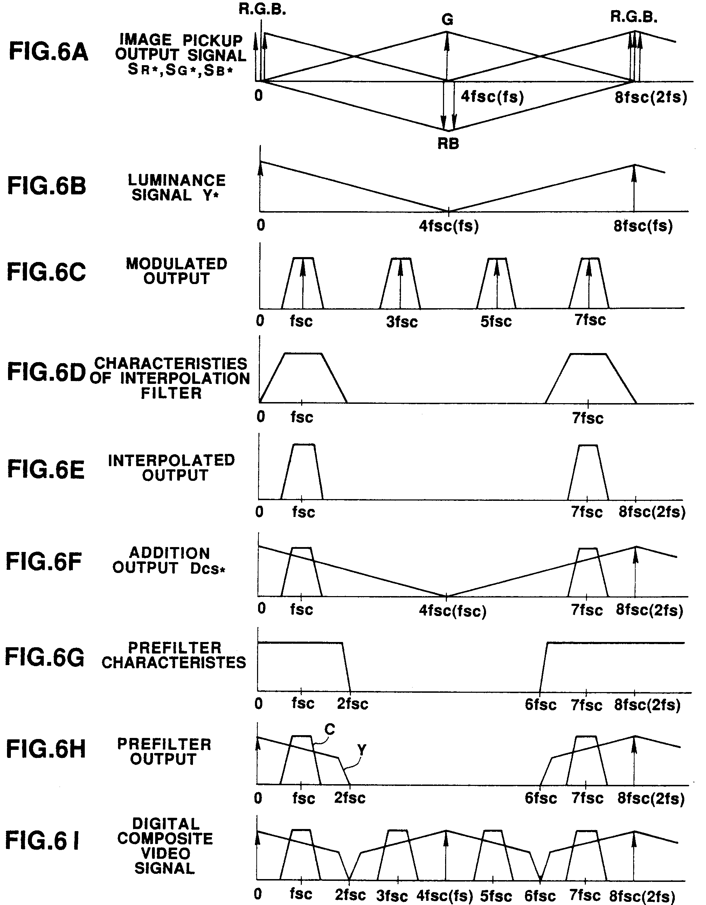

In this CHU, the three CCD image sensors 104R, 104G and 104B, forming an image pick-up device, are arranged in accordance with spatial pixel shifting in which, as shown in Figure 5, the sensors 104R and 104B for red colour and blue colour imaging are shifted with respect to the sensors 104G for green colour imaging, by a distance equal to one half the spatial pixel sampling period $\tau_s$. The three sensors 104R, 104G and 104B are driven by a CCD driving circuit, not shown, and imaging charges of the respective pixels are read by readout clocks having a sampling frequency $f_S$ equal to four times the colour sub-carrier frequency $f_{SC}$, or $4f_{SC}$.

Of the three sensors 104R, 104G and 104B, operating in accordance with spatial pixel shifting, the sensor 104G for green colour image pick-up and the sensor 104R for red colour image pick-up on one hand, and the sensor 104R for blue colour image pick-up on the other hand, perform spatial sampling on the three colour images of the object image at positions shifted by $\tau_{S/2}$ from one another. Thus, as shown in the signal spectrum of Figure 6A, the component of the sampling frequency $f_S$ of the green colour imaging output signal $S_{G^*}$ of the image sensor 104G is antiphase with respect to the component of the sampling frequency $f_S$ of each of the red colour imaging output signal $S_{R^*}$ of the sensor 104R and the blue colour imaging output signal $S_{B^*}$ of the sensor 104B.

The respective colour image pick-up output signals $S_{R^*}$, $S_{G^*}$ and $S_{B^*}$, read out from the sensors 104R, 104G and 104B with read-out clocks having the above-mentioned sampling frequency $f_S$ equal to $4f_{SC}$, are supplied to a level adjustment circuit 106 by way of correlation dual sampling circuits 105R, 105G and 105B, respectively.

The sampling circuits 105R, 105G and 105B process the image signals $S_{R^*}$, $S_{G^*}$, and $S_{B^*}$, from the sensors 104R, 104G and 104B by clamping the reset noise level and sample-holding the output level on the basis of the clamped noise level for reducing the reset noise.

The level adjustment circuit 106 also perform level adjustment, such as white balance adjustment, on the image signals $S_{R^*}$, $S_{G^*}$, and $S_{B^*}$, which are then supplied to A/D converters 107R, 107G and 107B, respectively.

Each of the A/D converters 107R, 107G and 107B is supplied with clocks by a timing generator, not shown, at a clock rate equal to the sampling rate $f_S$ of the image signals $S_{R^*}$, $S_{B^*}$, and $S_{B^*}$, that is a clock frequency $f_S$ equal to the read-out clocks of the sensors 104R, 104G and 104B. The A/D converters 107R, 107G and 107B directly digitize the image signals $S_{R^*}$, $S_{G^*}$, and $S_{B^*}$, at the clock rate $f_S$ to produce these digital colour signals $D_{R^*}$, $D_{G^*}$, and $D_{B^*}$, having the same output spectrum as the spectrum of the image signals $S_{R'}$, $S_{G'}$, and $S_{B'}$, shown in figure 6A.

The three digital colour signals $D_{R'}$, $D_{G'}$, and $D_{B'}$, are supplied to a signal processing section 108, while also being outputted at output terminals 109R, 109G and 109B, respectively.

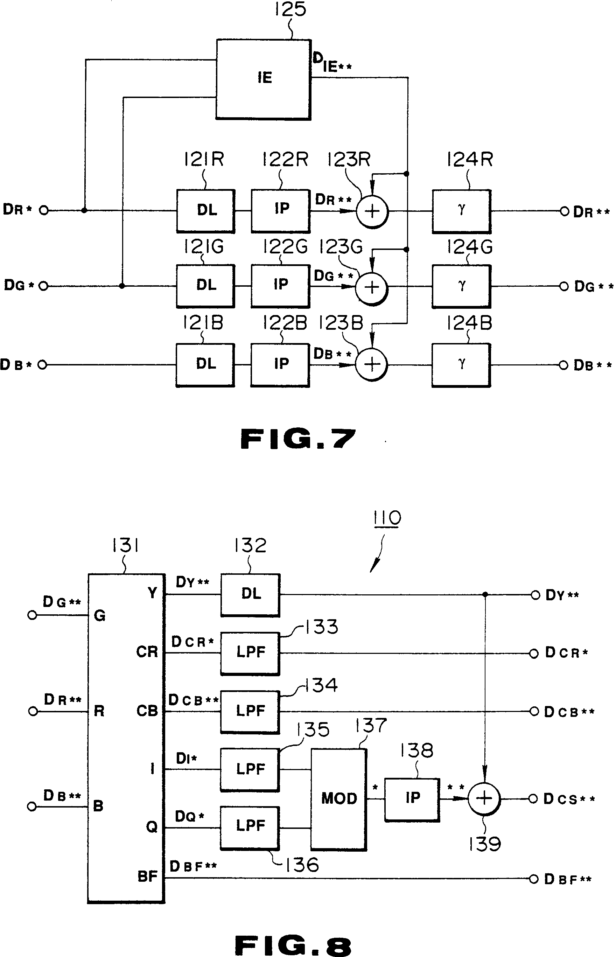

figure 7 shows the construction of the signal processor 108, composed of interpolating sections 122R, 122G and 122B, supplied with the three digital colour signals $D_{R'}$, $D_{G'}$ and $D_{B'}$, from the A/D converters 107R, 107G and 107B by way of delay circuits 121R, 121G and 121B, adders 123R, 123G and 123B, supplied with interpolated digital colour signals $D_{R'}$, $D_{G'}$, and $D_{B'}$, from the interpolating sections 122R, 122G and 122B, gamma correction circuits 124R, 124G and 124B, supplied with addition output signals from the adders 123R, 123G and 123B, and an image enhancement section 125 supplied with the digital colour signals $D_{R'}$, and $D_{G'}$ obtained by the A/D converters 107R and 107G, respectively.

The image enhancement section 125 produces a digital image enhancement section $D_{IE''}$ having a clock rate of $2f_S$ which is twice the clock rate $f_S$, or $8f_{SC}$, from the digital colour signals $D_{R'}$ and $D_{G'}$ produced by the A/D converters 107R and 107G at the clock rate $f_S$, or $4f_{SC}$. The image enhancement section 125 supplies the digital image enhancement signal $D_{IE''}$ at the clock rate of $2f_S$ to the adders 123R, 123G and 123B, respectively.

The interpolating sections 122R, 122G and 122B process the digital colour signals $D_{R'}$, $D_{G'}$ and $D_{B'}$, supplied from the A/D converters 107R, 107G and 107B at the clock rate $f_S$ or $4f_{SC}$, by interpolation, for producing the digital colour signals $D_{R''}$, $D_{G''}$ and $D_{B''}$ having the clock rate $2f_S$. The interpolating sections 122R, 122G and 122B supply the digital colour signals $D_{R''}$, $D_{G''}$ and $D_{B''}$ at the clock rate of $2f_S$ to the adders 123R, 123G and 123B, respectively.

The adders 123R, 123G and 123B also perform image enhancement processing by adding the digital image enhancement signal $D_{IE''}$, supplied from the image enhancement processing section 125 at the clock of $2f_S$, to the digital colour signals $D_{R''}$, $D_{G''}$ and $D_{B''}$, supplied from the interpolating sections 122R, 122G and 122B at the clock rate of $2f_S$, respectively. The adders 123R, 123G and 123B transmit the image-enhanced digital colour signals $D_{R''}$, $D_{G''}$ and $D_{B''}$ to the gamma correcting circuits 124R, 124G and 124B, respectively.

The gamma correction circuits 124R, 124G and 124B process the image enhanced digital colour signals $D_{R''}$, $D_{G''}$ and $D_{B''}$ from the adders 123R, 123G and 123B by gamma correction to output gamma-corrected digital colour signals $D_{R'''}$, $D_{G'''}$ and $D_{B'''}$, respectively.

In this manner, the signal processing section 108 outputs gamma-corrected and image-enhanced digital colour signals $D_{R'''}$, $D_{G'''}$ and $D_{B'''}$ at the clock rate equal to $2f_S$. The digital colour signals $D_{R'''}$, $D_{G'''}$ and $D_{B'''}$, output from the signal processing section 108 at the clock rate of $2f_S$, are supplied to a colour encoder 110, while also being supplied to D/A converters 111R, 111G and 111B.

The D/A converters 111R, 111G and 111B process the colour digital signals $D_{R'''}$, $D_{G'''}$ and $D_{B'''}$, supplied from the signal processor 108 with high resolution at the clock rate of $2f_S$, into an analogue form, to produce three colour analogue image output signals $R_{OUT}$, $G_{OUT}$ and $B_{OUT}$ which are outputted at output terminals 113R, 113G and 113B, respectively, by way of low-pass filters 112R, 112G and 112B, respectively.

The colour encoder 110, the detailed construction of which is shown in Figure 8, is made up of a matrix circuit 131, supplied with the $2f_S$-rate digital colour signals $D_{R''}$, $D_{G''}$ and $D_{B''}$ from the signal processing section 108, a delay circuit 132 supplied with a digital luminance signal $D_{Y''}$, formed by the matrix circuit 131, low-pass filters 133, 134, 135 and 136, supplied with digital colour difference signals $D_{CR'}$, $D_{CB'}$, $D_{I'}$ and $D_{Q'}$, formed by the matrix circuit 131, a modulation circuit 137, supplied with digital colour difference signals $D_{I'}$, and $D_{Q'}$, formed by the matrix circuit 131, by way of the low-pass filters 135 and 136, an interpolating circuit 138, supplied with the modulated output signal from the modulating circuit 137, and an addition circuit 139, supplied with the interpolated output signals from the interpolating circuit 138 and with the digital luminance signal $D_{Y''}$ by way of the delay circuit 132.

The matrix circuit 131 performs matrix processing on the $2f_S$ clock rate digital colour signals $D_{R''}$, $D_{G''}$ and $D_{B''}$ to produce the $2f_S$ clock rate digital luminance signal $D_{Y''}$, a $2f_S$ clock rate digital video signal $D_{BF''}$ for viewfinder, and the $f_S$ clock rate digital colour difference signals $D_{CR'}$, $D_{CB'}$, $D_{I'}$ and $D_{Q'}$. The $2f_S$ clock rate digital luminance signal $D_{Y''}$, formed by the matrix circuit 131, corresponds to the luminance signal $Y^{**}$ having the frequency distribution shown in Figure 6B.

The colour encoder 110 outputs, as the digital component video signal for the digital colour signals $D_{R''}$, $D_{G''}$ and $D_{B''}$, the digital luminance signal $D_{Y''}$ from the matrix circuit 131 by way of the delay circuit 132, while outputting the digital colour difference signals $D_{CR'}$ and $D_{CB'}$ from the matrix circuit 131 by way of the low-pass filters 133 and 134. The delay circuit 132 provides the digital luminance signal $D_{Y''}$ with delay characteristics corresponding to the low-pass filters 133 and 134.

The modulating circuit 137 of the colour encoder 110 performs a quadrature two-phase modulation on the digital colour difference signals $D_{I'}$ and $D_{Q'}$ supplied by way of the low-pass filters 135 and 136. The modulated output signal from the modulating circuit 137 corresponds to the modulated colour difference signal containing the odd harmonics of the colour sub-carrier frequency $f_{SC}$ and having the frequency distribution as shown in Figure 6C.

The interpolating circuit 138 processes the modulated output signal from the modulating circuit 137 by a digital filtering operation for extracting $f_{SC}$ and $7f_{SC}$ components, by filtering characteristics shown in Figure 6D, to produce a digital modulated colour difference signal having the clock rate $2f_S$ corresponding to $8f_{SC}$ and the frequency distribution as shown in Figure 6E.

The addition circuit 139 of the colour encoder 110 adds the digital luminance signal $D_{Y^{..}}$ and the $2f_S$ rate digital modulated colour difference signal to form the digital composite video signals $D_{CS^{..}}$ having the frequency distribution shown in Figure 6F.

Thus the colour encoder 110 produces and outputs, from the $2f_S$ rate digital colour signals $D_{R^{..}}$, $D_{G^{..}}$ and $D_{B^{..}}$ gamma corrected and image enhanced by the signal processor 108, the digital component video signals, composed of the $2f_S$ rate high resolution digital luminance signal $D_{Y^{..}}$ and the $f_S$ rate digital colour difference signals $D_{CR^{.}}$ and $D_{CB^{.}}$, while producing and outputting the $2f_S$ rate high resolution digital composite video signal $D_{CS^{..}}$ and the digital video signal $D_{BF^{..}}$ for a viewfinder.

The digital component video signals, that is the digital luminance signal $D_{Y^{..}}$ and the digital colour difference signals $D_{CB^{.}}$ and $D_{CB^{.}}$, output ted from the colour encoder 110, are supplied to D/A converters 111Y, 111CR and 111CB (Figure 4).

The D/A converters 111Y, 111CR and 111CB process the digital luminance signal $D_{Y^{..}}$ and the digital colour difference signals $D_{CR^{.}}$ and $D_{CB^{.}}$ into analogue component video signals $Y_{OUT}$, $CR_{OUT}$ and $CB_{OUT}$ which are outputted at the analogue video signal output terminals 113Y, 113CR and 113CB, respectively, by way of the low-pass filters 112Y, 112CR and 112CB, respectively.

The digital composite video signal $D_{CS^{..}}$, outputted from the colour encoder 110 is supplied to a D/A converter 111CS, while being outputted at an output terminal 109CS.

The D/A converter 111CS processes the $2f_S$ clock rate high resolution digital composite video signal $D_{CS^{..}}$ into an analogue composite video signal $CS_{OUT}$, which is outputted at an output terminal 113CS by way of the low-pass filter 112CS.

The digital video signal $D_{BF^{..}}$ for a viewfinder, outputted from the colour encoder 110, is supplied to a D/A converter 111BF which processes the digital video signal $D_{BF^{..}}$ into analogue form to produce a video signal $BF_{OUT}$ for a viewfinder. The video signal $BF_{OUT}$ is supplied via a low-pass filter 112BF to an electronic viewfinder, not shown, from output terminal 113BF.

With this colour video camera, since the three colour image output signals $S_{R^{.}}$, $S_{G^{.}}$ and $S_{B^{.}}$, produced by the CCD image sensors 104R, 104G and 104B, are processed by the a/D converters 107R, 107G and 107B into digital colour signals $D_{R^{.}}$, $D_{G^{.}}$ and $D_{B^{.}}$ which are outputted at the output terminals 109R, 109G and 109B, an external system for handling the digital colour signals $D_{R^{.}}$, $D_{G^{.}}$ and $D_{B^{.}}$ can be connected to the output terminals 109R, 109G and 109B. On the other hand, since the digital colour signals $D_{R^{.}}$, $D_{G^{.}}$ and $_{B^{.}}$, formed by the A/D converters 107R, 107G and 107B are processed by the signal processor 108 into gamma corrected and image enhanced interpolated $2f_S$ clock rate digital colour signals $D_{R^{..}}$, $D_{G^{..}}$ and $D_{B^{..}}$ which are processed by the D/A converters 111R, 111G and 111B into the corresponding analogue colour signals $R_{OUT}$, $G_{OUT}$ and $B_{OUT}$, which are outputted at the output terminals 113R, 113G and 113B, an external system for handling the analogue colour signals $R_{OUT}$, $G_{OUT}$ and $B_{OUT}$ may be connected to the output terminals 113R, 113G and 113B. In addition, since the $2f_S$ clock rate digital colour signals $D_{R^{..}}$, $D_{G^{..}}$ and $D_{B^{..}}$, produced by the signal processor 108, are processed by the colour encoder 110 to produce the digital component video signals, that is the digital luminance signal $D_{Y^{..}}$ and the digital colour difference signals $D_{CR^{.}}$ and $D_{CB^{.}}$, as well as the digital composite video signals $D_{CS^{..}}$, which digital composite video signal $D_{SC^{..}}$ is outputted at the output terminal 109CS, an external device for handling the digital composite video signal $D_{C^{..}}$ can be connected to the output terminal 109CS. Since the digital component image signals, that is the digital luminance signal $D_{Y^{..}}$ and the digital colour difference signals $D_{CR^{.}}$ and $D_{CB^{.}}$, produced by the colour encoder 110, are processed by the D/A converters 111Y, 111CR and 111CB into analogue component video signals $Y_{OUT}$, $CR_{OUT}$ and $CB_{OUT}$ which are outputted at the output terminals 113Y, 113CR and 113CB, an external system for handling the analogue component video signals $Y_{OUT}$, $CR_{OUT}$ and $CB_{OUT}$ may be connected to the output terminals 113Y, 113CR and 113CB. Furthermore, since the digital composite video signals $D_{CS^{..}}$, formed by the colour encoder 110, are processed by the D/A converter 111CS into the corresponding analogue video signals $CS_{OUT}$, which are outputted at the output terminal 113CS, an external system for handling the analogue composite video signals $CS_{OUT}$ may be connected to the output terminal 113CS.

The CHU includes a control circuit block 114 enclosed therein and connected to control signal terminals 109CTL and 113CTL, a synchronizing circuit block 115 enclosed therein and connected to a synchronizing signal input terminal 113SYNC, a microphone input terminal 109MCI, connected to a signal line for voice signals, obtained at a microphone, not shown, and a microphone output terminal 109MCO, connected to the microphone input terminal 109MCI.

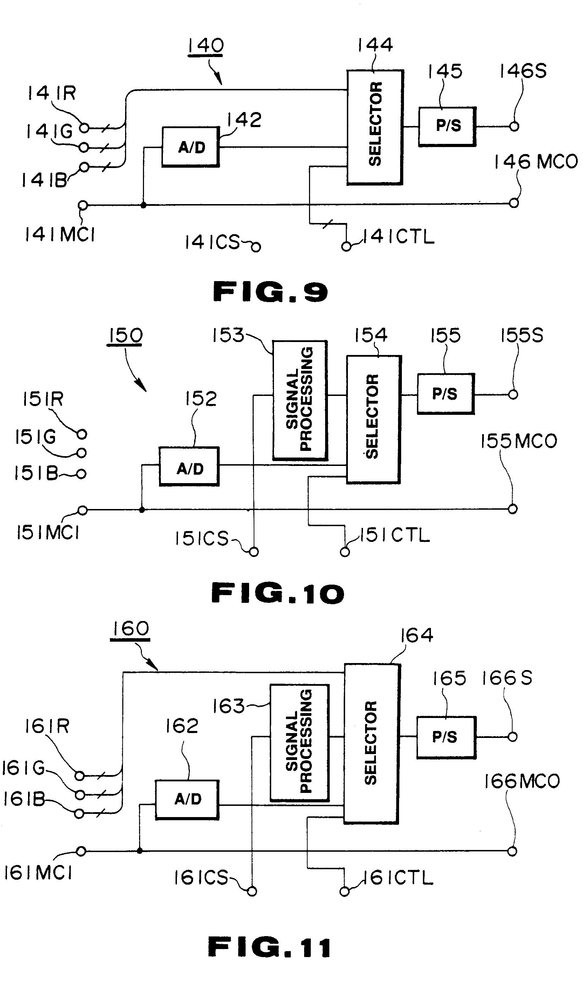

Various adapters, shown in Figures 9, 10 and 11 are provided in connection with the above-described CHU.

Figure 9 shows an adapter unit 140 for transmitting the digital colour signals to a CCU. The adapter unit 140 is provided with digital colour signal input terminals 131R, 141G and 141B, associated with the digital colour signal output terminals 109R, 109G and 109B on the CHU, a digital composite video signal input terminal 141CS, associated with the digital composite video signal output terminal 109CS on the CHU, a microphone input terminal 141MCI, associated with the microphone output terminal 109MCO on the CHU, and with a control signal terminal 141CTL, associated with the control signal terminal 109CTL on the CHU. The adapter unit 140 is also provided with an A/D converter 142 connected to the microphone input terminal 141MCI, a data selector 144, to the data input terminals of which are connected the output of the A/D converter 142, the digital colour signal output terminals 109R, 109G and 109B and the control signal terminal 141CTL, a P/S converter 145, connected to the output terminal of the data selector 144, a serial signal output terminal 146S, connected to the output terminal of the P/S converter 145 and a microphone output terminal 146MCO, connected to the microphone input terminal 141MCI.

In the adapter unit 140, the microphone input terminal 141MCI is connected to the microphone output terminal 109MCO of the CHU. It is at the microphone input terminal 14MCI that analogue voice signals are supplied from the CHU by means of the microphone output terminal 109MCO. The analogue voice signals, supplied to the microphone input terminal 141MCI, are outputted in the analogue form by means of the microphone output terminal 146MCO, while being digitized by the A/D converter 142 and supplied by way of the data selector 144 to the P/S converter 145 so as to be converted from parallel data into serial data and outputted as serial data at the data output terminal 146S.

The digital colour signal input terminals 141R, 141G and 141B are connected to the digital colour signal output terminals 109R, 109G and 109B on the main body of the colour video camera. It is at the digital colour signal input terminals 141R, 141G and 141B that the digital colour signals $D_{R^*}$, $D_{G^*}$ and $D_{B^*}$, are supplied from the digital colour signal output terminals 109R, 109G and 109B, respectively. The digital colour signals $D_{R^*}$, $D_{G^*}$ and $D_{B^*}$, are passed by the data selector 144 to the P/S converter 145 so as to be converted from parallel data into serial data which are outputted at the data output terminal 146S.

The control signal terminal 141CTL is connected to the control signal terminal 109CTL of the main body of the video camera. It is at the control signal terminal 141CTL that control signals are supplied from the CHU by way of the control signal terminal 109CTL. These control signals are supplied to the P/S converter 145 by the data selector 144 so as to be converted from parallel data into serial data which are outputted at the signal output terminal 146S.

The digital composite video signal input terminal 141CS is connected to the digital composite video signal output terminal 109CS of the CHU, and is not connected to any components of the adapter unit 140.

Figure 10 shows another adapter unit 150, which is for supplying digital component video signals to a digital VTR for recording. The adapter unit 150 is provided with digital colour signal input terminals 151R, 151G and 151B, a digital composite video signal input terminal 151CS, a microphone input terminal 151MCI and a control signal terminal 151CTL, associated with the digital colour signal output terminals 109R, 109G and 109B, the digital composite video signal output terminal 109CS, the microphone output terminal 109MCO and the control signal terminal 109CTL of the CHU, respectively.

The adapter unit 150 includes an A/D converter 152 connected to the microphone input terminal 151MCI, a signal processor 153 connected to the digital composite video signal input terminal 151CS, a data selector 154, to the data input terminals of which are connected the outputs of the signal processor 153 and the A/D converter 152 and the control signal terminal 151CTL, a P/S converter 155, connected to the output terminal of the data selector 154, a data output terminal 155S connected to the output of the P/S converter 155, and a microphone output terminal 155MCO, connected to the microphone input terminal 151MCI.

With the adapter unit 150, the microphone input terminal 151MCI is connected to the microphone output terminal 109MCO of the CHU. It is at the microphone input terminal 151MCI that analogue voice signals are supplied from the CHU by way of the microphone output terminal 109MCO. The analogue voice signals, supplied to the microphone input terminal 151MCI, are outputted in analogue form by way of the microphone output terminal 155MCO, while being digitized by the A/D converter 152 and supplied to the P/S converter 155 by the data selector 154 so as to be converted from parallel data into serial data and outputted as serial data at the data output terminal 155S.

The digital composite video signal input terminal 151CS is connected to the digital composite video signal output terminal 109CS of the CHU. It is at the digital composite video signal input terminal 151CS that the digital composite video signal $D_{CS^{**}}$ is supplied from the CHU by way of the digital composite video signal output terminal 109CS. The digital composite video signals $D_{CS^{**}}$, supplied to the digital composite video signal input terminal 151CS, are bandwidth-limited to about $f_S/2$ or less, as shown in Figure 6H, by a prefilter in the signal processor 153 having filtering characteristics as shown in Figure 6G. The bandwidth limited signals are then converted by down-sampling into digital composite video data $D_{CS^*}$ having the clock rate of $f_S$ as shown in Figure 61. The $f_S$ clock rate digital composite video data $D_{CS^*}$, obtained by the signal processor 153, are supplied to the P/S converter 155 by the data selector 154 so as to be converted from parallel data into serial data which are outputted at the data output terminal 155S.

The control signal terminal 151CTL is connected to the control signal terminal 109CTL of the CHU. It is at the control signal terminal 151CTL that control signals are supplied from the CHU by way of the control signal terminal 109CTL. The control signals supplied to the control signal terminal 151CTL are supplied by the data selector 154 to the P/S converter 155, by which the signals are converted from parallel data into serial data so as to be outputted as serial data at the data output terminal 155S.

The digital colour signal input terminals 151R, 151G and 151B are to be connected to the digital colour signal output terminals 109R, 109G and 109B of the CHU, and are not connected to any component within the adapter unit 150.

Figure 11 shows a further adapter unit 160 for selectively outputting the digital colour signals $D_{R^*}$, $D_{G^*}$, $D_{B^*}$ or the digital composite video signal $D_{CS^*}$ as serial data. The adapter unit 160 includes digital colour signal input terminals 161R, 161G and 161B, a digital composite video signal input terminal 161CS, a microphone input terminal 161MCI and a control signal terminal 161CTL, associated with the digital colour signal output terminals 109R, 109G and 109B, digital composite video signal output terminal 109CS, microphone output terminal 109MCO and the control signal terminal 109CTL, respectively, of the CHU.

The adapter unit 160 also includes an A/D converter 162, connected to the microphone input terminal 161MCI, a signal processor 163 connected to the digital composite video signal input terminal 161CS, a data selector 164 to the data input of which are connected the outputs of the signal processing section 163 and the A/D converter 162, the digital colour signal input terminals 161R, 161G and 161B and the control signal terminal 161CTL, a P/S converter 165 connected to the output of the data selector 164, a data output terminal 166S connected to the output of the P/S converter 165, and a microphone output terminal 166MCO, connected to the microphone input terminal 161MCI.

The microphone input terminal 161MCI is to be connected to the microphone output terminal 109MCO of the CHU. It is at the microphone input terminal 161MCI that the analogue voice signals are supplied from the CHU by way of the microphone output terminal 109MCO. The analogue voice signals, supplied to the microphone input terminal 161MCI are outputted as analogue signals by way of the microphone output terminal 166MCO, while being digitized by the A/D converter 162 and supplied by the data selector 164 to the P/S converter 165, whereby the digital signals are converted from parallel data into serial data, so as to be outputted as serial data at the data output terminal 166S.

The digital colour signal input terminals 161R, 161G and 161B are to be connected to the digital colour signal output terminals 109R, 109G and 109B of the CHU. It is at these input terminals 161R, 161G and 161B that digital colour signals $D_{R^*}$, $D_{G^*}$ and $D_{B^*}$ are supplied by way of the output terminals 109R, 109G and 109B frim the CHU. The digital colour signals $D_{R^*}$, $D_{G^*}$ and $D_{B^*}$, supplied to the input terminals 161R, 161G and 161B, are supplied by way of the data selector 164 to the P/S converter 165, whereby the digital signals are converted from parallel data into serial data, so as to be outputted as serial data at the data output terminal 166S.

The signal composite video signal input terminal 161CS is to be connected to the digital composite video signal output terminal 109CS of the CHU. It is at the input terminal 161CS that the digital composite video signal $D_{CS^{**}}$ is supplied from the CHU by way of the digital composite video signal output terminal 109CS. The digital composite video signal $D_{CS^{**}}$ is converted by down-sampling by the signal processor 163 into the digital composite video signals $D_{CS^*}$ with a clock rate equal to $f_S$, which is then supplied by way of the data selector 164 to the P/S converter 165 whereby the digital signals are converted from parallel data into serial data so as to be outputted as the serial data at the data output terminal 166S.

The control signal terminal 161CTL is to be connected to the control signal terminal 161CTL of the CHU. It is at the input terminal 161CTL that control data are supplied from the CHU by way of the control signal terminal 109CTL. The control data are supplied by way of the data selector 164 to the P/S converter 165, so as to be thereby converted from parallel data into serial data which are outputted at the data output terminal 166S.

Although the video camera described has the adapters 140, 150 and 160 for converting the digital colour signals and the digital composite video signal from parallel data into output serial data provided in the camera head unit, P/S converting means for the digital colour signals and digital composite video signals may also be arranged within the main body of the video camera.

## Claims

1. A video camera for processing output signals from an imaging device to form video signals, the camera comprising:
   analogue to digital converting means (107R, 107G, 107B) for converting three colour signals outputted from first, second and third solid-state imaging devices (104R, 104G, 104B) into digital signals;

signal processing means (108, 110) for processing output signals from said analogue to digital converting means (107R, 107G, 107B) for forming a digital composite video signal;

a first output terminal (109R, 109G, 109B) for outputting three colour signals digitized by said analogue to digital converting means (107R, 107G, 107B); and

a second output terminal (109CS) for outputting said digital composite video signal formed by said signal processing means (108, 110).

2. A camera according to claim 1 further comprising parallel to serial converting means (145, 165) for converting the digitized three colour signals from said first output terminal (109R, 109G, 109B) into serial data, and a third output terminal (146S, 166S) for outputting output signals of said parallel to serial converting means (145, 165).

3. A camera according to claim 1 further comprising parallel to serial converting means (155, 165) for converting said digital composite video signal from said second output terminal (109CS) into serial data, and a third output terminal (155S, 166S) for outputting output signals of said parallel to serial converting means (155, 165).

4. A camera according to claim 1 further comprising switching means (164) for selectively outputting the three digitized colour signals from said first output terminal (109R, 109G, 109B) or the digital composite video signal from said second output terminal (109CS), parallel to serial converting means (165) for converting output signals from said switching means (164) into serial data, and a third output terminal (166S) for outputting output signals from said parallel to serial converting means (165).

5. A camera for processing output signals of an imaging device for forming video signals, the camera comprising:

analogue to digital converting means (107R, 107G, 107B) for converting three colour signals outputted from first, second and third solid-state imaging devices (104R, 104G, 104B) into digital signals;

signal processing means (108, 110) supplied with output signals of said analogue to digital converting means (107R, 107G, 107B) and arranged to form a digital composite video signal;

switching means (164) for selectively outputting the three digitized colour signals supplied from said analogue to digital converting means (107R, 107G, 107B) or the digital composite video signal supplied from said signal processing means (108, 110);

parallel to serial converting means ( 165 ) for converting output signals of said switching means (165) into serial data; and

an output terminal (166S) for outputting output signals of said parallel to serial converting means (165).

6. A video camera for processing output signals of an imaging device (1) for forming video signals, the camera comprising:

analogue to digital converting means (6GE, 6GO, 6RE, 6RO, 6BE, 6BO) for converting output signals of said imaging device (1) into digital signals;

signal processing means (8, 14) for processing output signals of said analogue to digital converting means (6GE, 6GO, 6RE, 6RO, 6BE, 6BO) for forming digital composite video signals (DCS) of a predetermined format;

parallel to serial converting means (25) for converting output signals of said signal processing means (8, 14) into serial data; and

an output terminal (26) for outputting output signals of said parallel to serial converting means (25).

7. A video camera for processing output signals of an imaging device (1) for forming video signals, the camera comprising:

analogue to digital converting means (6GE, 6GO, 6RE, 6RO, 6BE, 6BO) for converting output signals of said imaging device (1) into digital signals;

signal processing means (8, 14) for processing output signals of said analogue to digital converting means (6GE, 6GO, 6RE, 6RO, 6BE, 6BO) to form digital video signals of a pretermined format;

parallel to serial converting means (25) for converting output signals of said analogue to digital converting means (6GE, 6GO, 6RE, 6RO, 6BE, 6BO) into serial data;

a first output terminal (24) for outputting the distal video signals formed by said signal processing means (8, 14); and

a second output terminal (26) for outputting said serial data from said parallel to serial converting means (25).

8. A video camera for processing output signals of an imaging device to form video signals, the camera comprising:

a camera head unit (Figure 1) comprising analogue to digital converting means (6GE, 6GO, 6RE, 6RO, 6BE, 6BO) for converting output signals of said imaging device into digital signals, and parallel to serial converting means (7) for converting output signals of said analogue to digital converting means (6GE, 6GO, 6RE, 6RO, 6BE, 6BO) into serial data;

transmission means (9, 10) for transmitting serial data outputted from said parallel to serial converting means (7) of said camera head unit (Figure 1); and

a camera control unit (Figure 3) comprising serial to parallel converting means (42) for converting said serial data supplied from said parallel to serial converting means (7) by said transmission means (9, 10) into parallel data, signal processing means (44) for processing output signals of said serial to parallel converting means (42) to form digital video signals of a predetermined format, and an output terminal (62, 53) for outputting the video signals formed by said signal processing means.

9. A camera according to claim 8 wherein said camera control circuit (Figure 3) further comprises image converting means (43) for processing the output signals of said serial to parallel converting means (42) by image conversion for supplying resulting image-converted signals to said signal processing means (44).

10. A camera according to claim 9 wherein said image converting means (43) process said output signals of said serial to parallel converting means (42) by image conversion as a function of optical effects produced during light passage through an optical system thereof.

11. A camera according to claim 8 wherein:

said camera control unit (Figure 3) further comprises second analogue to digital converting means (59) for converting analogue video signals supplied from an external device into digital signals and second parallel to serial converting means (71) for converting output signals of said second analogue to digital converting means (59) into serial data; and wherein:

said camera head unit (Figure 1) further comprises second serial to parallel converting means (32) for converting said serial data supplied from said second parallel to serial converting means (71) by means for said transmission means (9, 10), and digital to analogue converting means (33) for converting output signals of said second serial to parallel converting means (32) into analogue signals and supplying said analogue signals to display means.

12. A camera according to claim 11 wherein said display means is a prompter.

13. A camera according to claim 8 wherein:

said camera control unit (Figure 3) further comprises second parallel to serial converting means (45) for converting video signals of a predetermined format produced by said signal processing means (44) into serial data; and wherein:

said camera head unit (Figure 1) further comprises second serial to parallel converting means (38) for converting said serial data supplied from said second parallel to serial converting means (45) by said transmission means (9, 10) into parallel data, digital to analogue converting means (12) for converting output signals of said second serial to parallel converting means (38) into analogue signals, and a viewfinder (13VF) for displaying output signals of said digital to analogue converting means (12).

14. A video camera for processing output signals of an imaging device (1) to form video signals, the camera comprising:

a camera head unit (Figure 1) comprising a solid-state imaging device (2G, 2R, 2B) from the totality of pixels of which imaging signals are read independently field by field on the basis of driving pulses supplied from driving means for said imaging device (2G, 2R, 2B), analogue to digital converting means (6GE, 6GO, 6RE, 6RO, 6BE, 6BO) for converting said imaging signals outputted from said solid-state imaging device (2G, 2R, 2B) into digital signals, and parallel to serial converting means (7) for converting output signals of said analogue to digital converting means (6GE, 6GO, 6RE, 6RO, 6BE, 6BO) into serial data;

transmission means (9, 10) for transmitting said serial data outputted from said parallel to serial converting means (7) of said camera head unit (Figure 1); and

a camera control unit (Figure 3) comprising serial to parallel converting means (42) for converting said serial data transmitted by said transmission means (9, 10) from said parallel to serial conversion means (7) into parallel data, signal processing means (44) for processing output signals of said serial to parallel converting means (42) to form digital video signals of a predetermined format, and an output terminal (62, 53) for outputting said digital video signals formed by said signal processing means (44).

15. A camera according to claim 14 wherein said camera control unit (Figure 3) further comprises image converting means (43) for processing said output signals of said serial to parallel converting means (42) by image conversion and supplying the processed signals to said signal processing means (44).

16. A camera according to claim 15 wherein said image converting means (43) processes said output signals of said serial to parallel converting means (42) by image conversion as a function of the optical effects produced during light passage through an optical system thereof.

17. A camera according to claim 14 wherein said camera control unit (Figure 3) further comprises second parallel to serial converting means (45) for converting video signals of a predetermined format produced by said signal processing means (44) into serial data; and wherein:
said camera head unit (Figure 1) further comprises second serial to parallel converting means for converting said serial data supplied from said second parallel to serial converting means (38) by means of said transmission means (9, 10) into parallel data, digital to analogue converting means (12) for converting output signals of said second serial to parallel converting means (38) into analogue signals, and a viewfinder (13VF) for displaying output signals of said digital to analogue converting means (12).

**FIG.1**

EP 0 463 827 A2

**FIG.2**

$$\frac{1}{2} \cdot \tau s$$

**FIG.5**

FIG.3

FIG.4

**FIG.6A** IMAGE PICKUP OUTPUT SIGNAL SR*,SG*,SB*

R.G.B.

G

R.G.B.

0      4fsc(fs)      8fsc(2fs)

RB

**FIG.6B** LUMINANCE SIGNAL Y*

0      4fsc(fs)      8fsc(fs)

**FIG.6C** MODULATED OUTPUT

0    fsc      3fsc      5fsc      7fsc

**FIG.6D** CHARACTERISTIES OF INTERPOLATION FILTER

0    fsc      7fsc

**FIG.6E** INTERPOLATED OUTPUT

0    fsc      7fsc    8fsc(2fs)

**FIG.6F** ADDITION OUTPUT Dcs*

0    fsc      4fsc(fsc)      7fsc    8fsc(2fs)

**FIG.6G** PREFILTER CHARACTERISTES

0    fsc    2fsc      6fsc    7fsc    8fsc(2fs)

**FIG.6H** PREFILTER OUTPUT

C

Y

0    fsc    2fsc      6fsc    7fsc    8fsc(2fs)

**FIG.6 I** DIGITAL COMPOSITE VIDEO SIGNAL

0    fsc    2fsc    3fsc  4fsc(fs)  5fsc  6fsc    7fsc    8fsc(2fs)

# FIG.7

# FIG.8

**FIG.9**

**FIG.10**

**FIG.11**